# EUROPÄISCHE PATENTSCHRIFT

(11) **EP 0 639 316 B1**
(45) Veröffentlichungstag und Bekanntmachung des Hinweises auf die Patenterteilung: **02.09.1998**
(21) Anmeldenummer: 93911790.9
(22) Anmeldetag: 03.05.1993
(51) Int. Cl.: H04N 7/00, H03M 13/00, H04N 7/035

(54) **VERFAHREN ZUM EMPFANGEN VON TELETEXTDATEN**
RECEPTION PROCESS FOR TELETEXT DATA
PROCEDE DE RECEPTION DE DONNEES TRANSMISES PAR TELETEXTE

(30) Priorität: 04.05.1992 DE 4214750
(43) Veröffentlichungstag der Anmeldung: 22.02.1995
(73) Patentinhaber: TELEFUNKEN Fernseh und Rundfunk GmbH, 30453 Hannover (DE)
(72) Erfinder: BRÜCKNER, Werner, D-8000 München 81 (DE); EITZ, Gerhard, D-8011 Poing (DE)
(86) Internationale Anmeldenummer: EP9301056
(87) Internationale Veröffentlichungsnummer: WO9322873

(56) Entgegenhaltungen:
- RUNDFUNKTECHNISCHE MITTEILUNGEN Bd. 32, Nr. 6, November 1988, NORDERSTEDT DE Seiten 269 - 280 G. EITZ U. A. 'Fehlerschutzstrategien für die Satellitenübertragung von Fernsehtext.'
- INTERNATIONAL BROADCASTING CONVENTION 1988 23. September 1988, BRIGHTON(UK) Seiten 323 - 327 , XP232964 M. P. GOLD U. A. 'Error Correction Strategies for Data Broadcasting.'

## Beschreibung

Die Erfindung bezieht sich auf Verfahren gemäß dem Oberbegriff des Patentanspruchs 1.

Zum Empfangen von Teletext-Daten, die innerhalb von Austastbereichen eines Fernsehsignals zyklisch übertragen werden, sind Einrichtungen bekannt, welche zur Selektion solcher Daten in der Lage sind.

Die Datenstrukturen der Teletext-Daten sind blockorientiert, d.h., mehrere kleinste logisch zusammengehörige Informationseinheiten sind zu Blöcken zusammengefaßt. Diese können durch Prüfinformationen (sog. "Cyclic Redundancy Check", abgekürzt "CRC") ergänzt werden, so daß decoderseitig anhand der Prüfinformationen die einzelnen Informationsblöcke auf das Vorhandensein von Fehlern, die aufgrund der Übertragungseigenschaften des Nachrichtenkanals entstanden sind, überprüft werden können. Eine Fehlerkorrektur ist damit jedoch nicht möglich.

Zur Korrektur von Übertragungsfehlern können innerhalb jedes Informationsblockes von Teletext-Daten Fehlerschutzinformationen (sog. "Forward Error Correction", abgekürzt "FEC", z.B. Hamming-, BCH- oder Reed-Salomon-Codes) mitübertragen werden, mit Hilfe derer entsprechend ihrer Korrekturfähigkeit ein oder mehrere gestörte Informationseinheiten allgemein n Informationseinheiten (n = positive, ganze Zahl) korrigiert werden können. Die Fehlerschutzinformationen stellen jedoch redundante Information dar, die je nach gewünschter Korrekturfähigkeit bis zu 100 % Redundanz gehen kann und dementsprechend die Übertragungskapazität bzw. Übertragungsgeschwindigkeit für die Nutzinformationen verringert. Ferner ist der Decoder nur in der Lage, so viele Fehler pro Informationsblock zu korrigieren, wie durch die coderseitige Wahl des Fehlerschutzcodes vorgegeben ist.

Der Artikel Eitz, G., Möll, G.: "Fehlerschutzstrategien für die Satellitenübertragung von Fernsehtext", RUNDFUNKTECHNISCHE MITTEILUNGEN 32 Nr. 6, Seiten 269 - 280 beschreibt Grundprinzipien der Fehlerkorrektur von Fernsehtextdaten sowie deren Kombination für einen effektiven Fehlerschutz. Jedoch benötigt die darin beschriebene Bitvariationsmethode zwei quasi-identische, zu unterschiedlichen Zeiten empfangene Informationsblöcke, weshalb die zur Fehlerkorrektur erforderliche Zeit entsprechend lange ist.

Die Aufgabe der Erfindung besteht demgegenüber darin, bei einem Verfahren der vorgenannten Art die decoderseitige Fehlerkorrekturfähigkeit je nach gewünschtem Aufwand zu variieren und gegebenenfalls über die Fehlerkorrekturfähigkeit des coderseitig vorgegebenen Fehlerschutzcodes zu erhöhen.

Diese Aufgabe wird erfindungsgemäß durch die kennzeichnenden Merkmale des Patentanspruchs 1 gelöst.

Vorteilhafte Weiterbildungen und Ausgestaltungen des erfindungsgemäßen Verfahrens ergeben sich aus den Unteransprüchen.

Die Erfindung wird nachstehend anhand der in den Zeichnungen dargestellten Ausführungsbeispiele näher erläutert. Es zeigt:
- Fig. 1: den schematischen Funktionsablauf bei der decoderseitigen Korrektur von n+z Fehlern in einem Datenblock aus einem Einlauf unter Benutzung von FEC, CRC und dem erfindungsgemäßen Verfahren "Variation I".
- Fig. 2: den gegenüber Fig. 1 genauer dargestellten Funktionsablauf des erfindungsgemäßen Verfahrens "Variation I".
- Fig. 3: ein Beispiel eines durch zwei Fehler gestörten Datenblocks und die einzelnen decoderseitigen Korrekturversuche nach dem erfindungsgemäßen Verfahren "Variation I".
- Fig. 4: eine allgemeine Übersicht über die decoderseitige Vorgehensweise bei der Korrektur eines Datenblocks mit zwei Einläufen.
- Fig. 5: den Funktionsablauf des erfindungsgemäßen Verfahrens "Variation II" an einem Beispiel mit zwei gestörten Datenblöcken aus zwei Einläufen, und die einzelnen decoderseitigen Korrekturversuche nach dem erfindungsgemäßen Verfahren "Variation II".

Im folgenden wird ein mit beliebig vielen Fehlern gestörter Datenblock betrachtet, der mit einem Vorwärtsfehlerschutz (FEC) zur Korrektur von n Fehlern und, abhängig von der Wahl des verwendeten FECs, mit der Möglichkeit des Erkennens von mehr als n Fehlern versehen ist. Ist der Datenblock durch mehr Fehler gestört, als der FEC korrigieren und ggf. erkennen kann, so tritt eine "Überlastung" des FECs auf, die sich in einer falschen Signalisierung äußert. Eine "Überlastung" des FECs bzw. eine mit der FEC erfolgten Korrektur kann vom Dekoder mit Hilfe des CRCs überprüft werden.

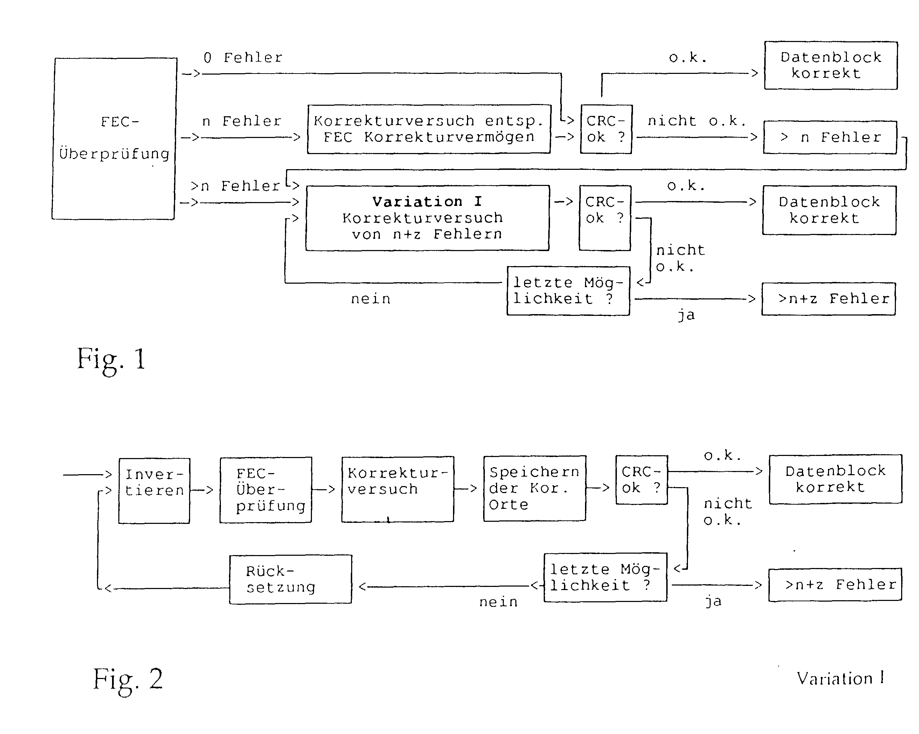

Jeder eintreffende Datenblock wird decoderseitig entsprechend dem mitgesendeten Fehlerschutz (FEC) überprüft (Fig. 1). Werden von der FEC keine Fehler festgestellt, so findet unmittelbar eine Überprüfung anhand der mitgesendeten Prüfinformation (CRC) statt. Dabei wird entweder festgestellt, daß der betreffende Datenblock korrekt ist - in diesem Fall kann der nächste Datenblock untersucht werden - oder daß der FEC überlastet und der Datenblock mit mehr als n Fehlern gestört ist. Wird jedoch bei der FEC - Überprüfung das Vorhandensein von maximal n Fehlern (entsprechend dem Korrekturvermögen des FECs) signalisiert, so erfolgt ein Korrekturversuch, wobei der Erfolg der Korrektur mit dem CRC überprüft wird. Bei positivem Ergebnis der Prüfung sind die Fehler korrigiert. Bei negativem Prüfergebnis ist die Fehlerkorrektur überfordert (d.h. der Block wurde mit mehr als n Fehlern gestört) und es können weitere Korrekturversuche nach dem als "Variation I" benannten Grundmuster erfolgen. Besteht bei dem gewählten FEC die Möglichkeit zur Erkennung von mehr als n Fehlern, so kann bei einer entsprechenden Signalisierung sofort die "Variation I" durchgeführt und neben n noch weitere z Fehler korrigiert werden. Das Grundmuster gemäß "Variation I" wird solange durchgeführt, bis entweder die CRC-Prüfung eine erfolgreiche Korrektur signalisiert oder alle Möglichkeiten der Variation von Fehlerpositionen erschöpft sind. Im letzteren Fall treten mehr als n+z Fehler im untersuchten Datenblock auf und "überlasten" damit sowohl den FEC als auch die "Variation I".

Fig. 2 zeigt einem gegenüber Fig. 1 genauer dargestellten Funktionsablauf von "Variation I". Zur Korrektur von n+z Fehlern werden
- an jeweils z Stellen die entsprechenden Informationseinheiten invertiert,
- eine FEC-Überprüfung durchgeführt,
- ein entsprechender Korrekturversuch gemäß dem Korrekturvermögen von n Fehlern vorgenommen und
- eine Überprüfung auf richtige Korrektur mit dem CRC vorgenommen.

Außerdem werden die Positionen der invertierten und der von der FEC korrigierten Informationseinheiten in einer Tabelle abgelegt. Bei einem erfolglosen Korrekturversuch werden die veränderten Informationseinheiten entsprechend der Tabelle zurückgesetzt.

In einem nächsten Schritt werden versuchsweise weitere z Informationseinheiten invertiert, ein Korrekturversuch mit FEC und eine Überprüfung der Korrektur mit CRC durchgeführt (Fig.2). Dieser Vorgang wird solange wiederholt, bis entweder eine richtige Korrektur der n+z Fehlern erfolgt ist, oder alle möglichen Invertierungen von jeweils z Informationseinheiten durchgeführt worden sind. Im letzteren Fall ist der Datenblock durch mehr als n+z Fehler gestört und kann deshalb nicht durch "variation I" korrigiert werden. Der Decoder muß einen identischen Datenblock aus einem weiteren Einlauf abwarten. In einer besonderen Ausführungsform des Grundmusters gemäß "Variation I" werden bei weiteren versuchsweisen Invertierungen die zuvor durchgeführten Invertierungen und die von der FEC vorgeschlagenen Korrekturen berücksichtigt. Dadurch wird die Anzahl der versuchsweisen Invertierungen erheblich eingeschränkt.

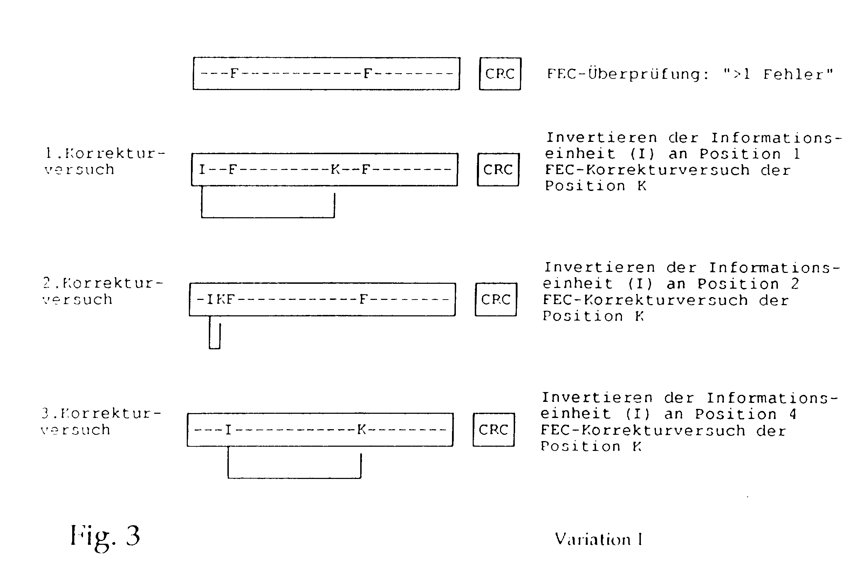

Das Grundmuster gemäß "Variation I" wird in Fig. 3 an Hand eines Beispiels näher gezeigt. Ein mit zwei Fehlern gestörter Datenblock mit 24 Informationseinheiten sei mit einem FEC mit der Korrekturfähigkeit von einem Fehler und der Möglichkeit zur Erkennung von zwei Fehlern ausgestattet, z.B. mit einem erweiterten Hamming-Schutz. Man erkennt, daß die Korrekturfahigkeit des FEC "überlastet" und eine decoderseitige Korrektur der zwei Fehler mit den herkömmlichen Verfahren nicht möglich ist. Da die FEC-Überprüfung signalisiert, daß mehr als zwei Fehler vorliegen, wird ein erster Korrekturversuch nach dem Grundmuster gemäß "Variation I" durchgeführt, indem die Informationseinheit an der mit I bezeichneten, ersten Position versuchsweise invertiert, eine FEC-Überprüfung und ein entsprechender Korrekturversuch an der Informationseinheit an der mit K gekennzeichneten Position vorgenommen wird. Bei einem unrichtigen Invertierungsversuch wird der Datenblock durch drei Fehler gestört und der überlastete FEC führt bei seinem Korrekturversuch einen weiteren Fehler hinzu. Der erfolglose Korrekturversuch wird vom CRC signalisiert und die invertierten und die von der FEC veränderten Informationseinheiten werden in den Vorzustand zurückgesetzt. Anschließend werden dieselben Verfahrensschritte solange durchgeführt, bis eines der zwei gestörten Informationseinheiten erreicht und invertiert ist. Bei jedem Korrekturversuch werden die vorgeschlagene Informationseinheit I und der Korrekturversuch an der Informationseinheit K vom Dekoder in einer Tabelle vermerkt. Da eine versuchsweise Invertierung der Informationseinheit K wiederum zu einem FEC-Korrekturvorschlag an der Informationseinheit I führt, kann in diesem Fall die Anzahl der maximal notwendigen Korrekturversuche halbiert werden, d.h. es sind maximal 12 Versuche notwendig. Beim zweiten Korrekturversuch wird ähnlich wie im Ersten vorgegangen. Da bei dem dritten Korrekturversuch die dritte Informationseinheit in der Tabelle bereits enthalten ist, kann sie übersprungen und die Informationseinheit an der vierten Stelle invertiert werden. In diesem Fall ist von den zwei Fehlern ein Fehler gefunden worden, der vom FEC erkannt und korrigiert wird. Die folgende CRC Überprüfung bestätigt die Richtigkeit des Korrekturversuchs.

Ähnlich der hier gezeigten Vorgehensweise können auch mehrere zusätzliche Fehler korrigiert werden. Die Gesamtzahl der notwendigen Korrekturversuche hängt dabei von der gewählten zusätzlichen Fehleranzahl z und der Blocklänge ab. Sollen beispielsweise gegenüber der FEC-Korrekturfähigkeit hinaus zwei weitere Fehler korrigiert werden, so sind jeweils zwei Informationseinheiten zu invertieren und bei einer Blocklänge von 24 Informationseinheiten maximal 232 Korrekturversuche durchzufuhren.

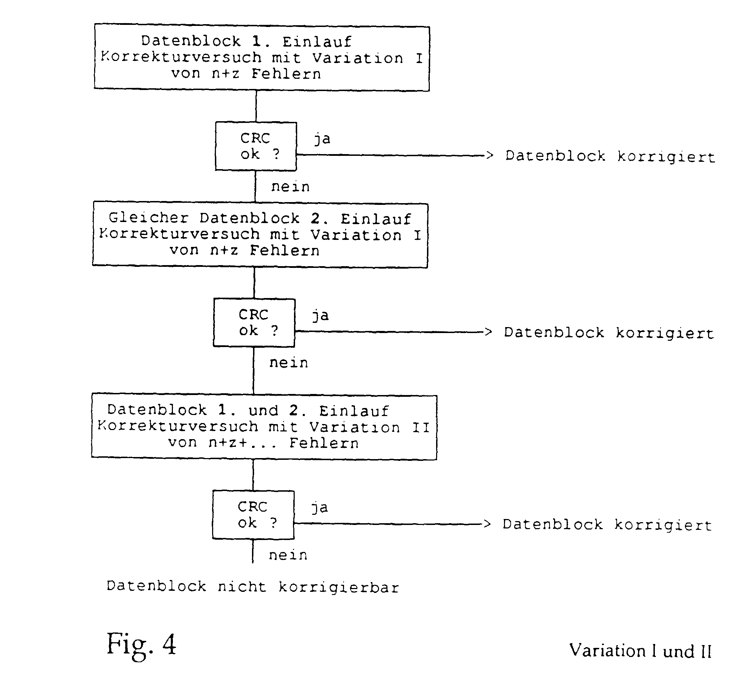

Fig. 4 zeigt eine allgemeine Übersicht über die decoderseitige Vorgehensweise bei der Korrektur eines stark gestörten Datenblocks. Ist eine Korrektur mit dem FEC und dem Grundmuster gemäß "Variation I" nicht erfolgreich, so muß ein weiterer Einlauf des gleichen Datenblocks abgewartet und zwischengespeichert werden. Ist auch bei diesem, praktisch identischen Datenblock mit den erwähnten Verfahren keine erfolgreiche Korrektur möglich, so wird das Grundmuster gemäß "Variation II" durchgeführt. Dabei werden decoderseitig die Daten beider Einläufe miteinander verglichen und die Anzahl der Unterschiede und ihre Positionen innerhalb des Datenblocks festgestellt. Die nun folgenden Korrekturversuche laufen ähnlich wie bei dem Grundmuster gemäß "Variation I" ab, jedoch werden nur die unterschiedlichen Informationseinheiten an den betreffenden Positionen schrittweise invertiert und jeweils ein Korrekturversuch durchgeführt. Die Anzahl z der bei jedem Korrekturversuch gleichzeitig zu invertierenden Informationseinheiten wird gegenüber den vorigen, erfolglosen Versuchen erhöht. Bei der Wahl von z (und damit der Anzahl der zusätzlich korrigierbaren Fehler) kann darüberhinaus die Anzahl der als unterschiedlich erkannten Informationseinheiten und die interne Rechenleistung berücksichtigt werden. Wie bei der "Variation I" wird auch bei der "Variation II" nach jedem Korrekturversuch mit dem CRC eine Überprüfung des Datenblocks auf Richtigkeit vorgenommen.

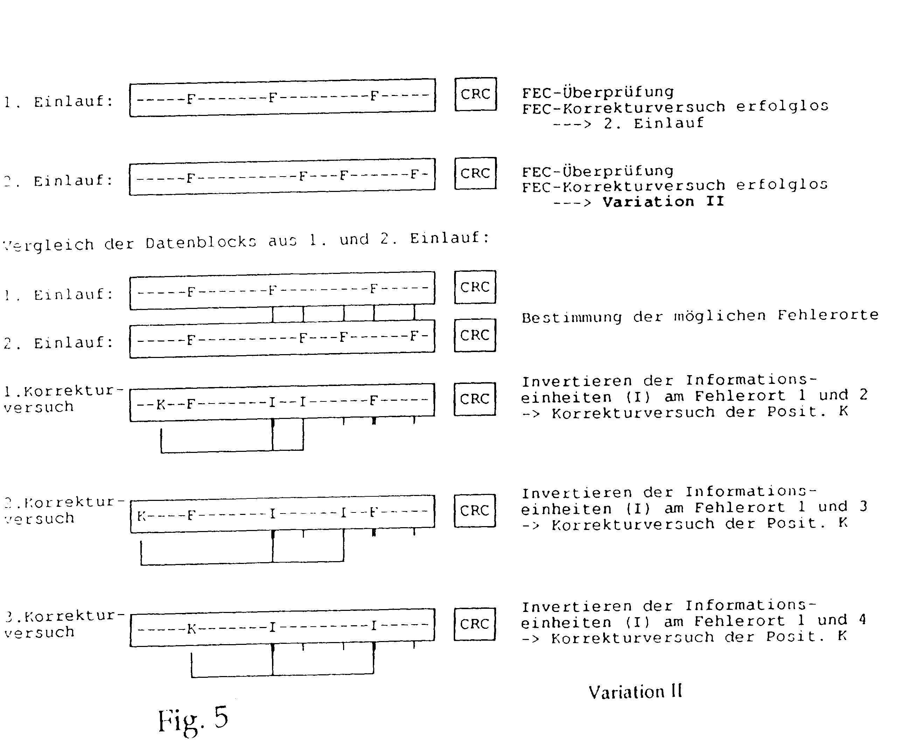

Der Ablauf der einzelnen Korrekturschritte wird anhand von Fig. 5 näher erläutert. Figur 5 zeigt zwei Einläufe zweier gleicher, mit drei und vier Fehlern gestörter Datenblöcke mit einer FEC Korrekturfähigkeit von n=1 Fehlern. Entsprechend Figur 4 können die Daten beider Einläufe nicht korrigiert werden, da der FEC überlastet und die "Variation I" mit einer schrittweisen Invertierung nur einer einzigen Informationseinheit (z=1) erfolglos ist. Durch den Vergleich beider Einläufe werden die unterschiedlichen Informationseinheiten und damit die möglichen Fehlerpositionen erkannt. Wie in Figur 5 dargestellt, werden durch den Vergleich fünf mögliche Fehlerorte bestimmt. Die Position eines weiteren Fehlers wird dagegen, bedingt durch eine an der gleichen Position jedes Datenblocks auftretende Störung (z.B. ein Echo), nicht erkannt. Unter Berücksichtigung der zuvor durchgeführten, erfolglosen Korrekturversuche werden nun jeweils die Informationseinheiten an zwei der fünf möglichen Fehlerorte gleichzeitig invertiert und ein Korrekturversuch durchgeführt.

Beim ersten Korrekturversuch werden die Informationseinheiten I des Datenblocks aus dem ersten Einlauf am Fehlerort 1 und 2 versuchsweise invertiert, eine FEC-Überprüfung und ein entsprechender Korrekturversuch der Informationseinheit K vorgenommen. In weiteren Versuchen werden danach die Informationseinheiten an den möglichen Fehlerorten 1 und 3 und schließlich an 1 und 4 invertiert. Bei dem dritten Versuch werden zwei der drei Fehlerorte gefunden und ermöglichen es so dem FEC, den dritten Fehler an dem bisher nicht bekannten Fehlerort zu korrigieren. Im ungünstigsten Fall lassen sich die drei Fehler nach maximal 10 Korrekturversuchen finden. Werden dagegen beim Vergleich der Datenblöcke zweier Einläufe sieben mögliche Fehlerorte detektiert, so sind die Fehlerpostionen nach maximal elf Korrekturversuchen bekannt.

## Patentansprüche

1. Verfahren zum Empfangen von sich periodisch wiederholenden, aus digitalen Informationsblöcken bestehenden Teletextdaten, welche in einem Fernsehsignal enthalten sind, bei dem die Zeitbereiche, in welchen die sich periodisch wiederholenden Teletextdaten zu erwarten sind, ausgewählt und die innerhalb jedes dieser Zeitbereiche empfangenen Informationsblöcke selektiert und dahingehend ausgewertet werden, daß anhand einer mitübertragenen Fehlerschutzinformation (FEC) entsprechend deren Korrekturfähigkeit n fehlerhaft übertragene Informationseinheiten korrigiert werden, und daß anhand einer mitübertragenen Prüfinformation (CRC) die Richtigkeit der Nutzinformation innerhalb jedes selektierten und gegebenenfalls korrigierten Informationsblocks festgestellt wird, wobei n eine positive ganze Zahl ist, und daß die Fehlerprüfung für den betrachteten Informationsblock vorzeitig abgebrochen wird, sobald in einem Informationsblock die Nutzinformation anhand der mitübertragenen Prüfinformation als fehlerfrei erkannt wird, **dadurch gekennzeichnet,** daß von den Informationseinheiten des betrachteten Informationsblocks schrittweise eine oder mehrere Informationseinheiten invertiert werden, daß bei jedem Inversionsschritt anhand der Fehlerschutzinformation (FEC) ein Korrekturversuch bei n Informationseinheiten erfolgt und nach jedem Korrekturversuch anhand der Prüfinformation festgestellt wird, ob die Korrektur erfolgreich war, daß im Falle einer erfolgreichen Korrektur die Fehlerprüfung abgebrochen wird und daß nach jedem erfolglosen Korrekturversuch die invertierten und versuchsweise korrigierten Informationseinheiten in den Anfangszustand rückversetzt werden.

2. Verfahren nach Anspruch 1, dadurch gekennzeichnet, daß im Falle einer erfolglosen Korrektur die Positionen der invertierten und versuchsweise korrigierten Informationseinheiten festgehalten und bei folgenden Korrekturversuchen ausgelassen werden.

3. Verfahren nach Anspruch 1 oder 2, dadurch gekennzeichnet, daß im Falle eines Mißerfolgs der Korrekturmaßnahmen bei einem später empfangenen, mit Ausnahme von Übertragungsfehlern identischen (quasi-identischen) Informationsblock die Korrekturmaßnahmen wiederholt werden.

4. Verfahren nach Anspruch 3, dadurch gekennzeichnet, daß im Falle des Mißerfolgs der wiederholten Korrekturmaßnahmen eine weitere Fehlerkorrektur durch Vergleich der quasi-identischen, zu unterschiedlichen Zeiten empfangenen Informationsblöcke vorgenommen wird, wobei von den aufgrund des Vergleichs beider Informationsblöcke als unterschiedlich erkannten Informationseinheiten eines der beiden Informationsblöcke oder beider Informationsblöcke schrittweise eine oder mehrere Informationseinheiten invertiert werden, daß bei jedem Inversionsschritt anhand der Fehlerschutzinformation ein Korrekturversuch bei n, als unterschiedlich erkannten Informationseinheiten erfolgt und daß nach jedem Korekturversuch anhand der Prüfinformation festgestellt wird, ob die Korrektur erfolgreich war, daß im Falle einer erfolgreichen Korrektur die Fehlerprüfung abgebrochen und der zunächst versuchsweise korrigierte Informationsblock als richtig erkannter Informationsblock bewertet wird und daß nach jedem erfolglosem Korrekturversuch die invertierten und versuchsweise korrigierten Informationseinheiten in den Anfangszustand rückversetzt werden.

## Claims

1. Method for receiving periodically repeating teletext data which comprise digital information blocks and are contained in a television signal, in the case of which the time periods in which the periodically repeating teletext data can be expected are chosen and the information blocks which have been received within each of these time periods are selected and evaluated in that n incorrectly transmitted information units are corrected using additionally transmitted error protection information (FEC) , in a corresponding manner to their correction capability, and in that the correctness of the wanted information within each selected, and possibly corrected, information block is determined using additionally transmitted check information (CRC), n being a positive integer, and in that the error check for the information block under consideration is terminated prematurely as soon as the wanted information in an information block has been identified as being error free using the check information which is also transmitted,
characterized in that
one or more information units of the information units in the information block under consideration are inverted step by step, in that a correction attempt is carried out for n information units for each inversion step using the error protection Information (FEC) and the check information is used after each correction attempt to determine whether the correction was successful, in that the error check is terminated in the event of successful correction, and in that, after every unsuccessful correction attempt, the inverted information units which an attempt has been made to correct are reset to the the initial state after every unsuccessful correction attempt.

2. Method according to Claim 1, characterized in that, in the event of unsuccessful correction, the positions of the inverted information units, which an attempt has been made to correct, are fixed and are omitted in subsequent correction attempts.

3. Method according to Claim 1 or 2, characterized in that, in the event of the correction measures being unsuccessful, the correction measures are repeated in an information block which is received later and is identical (virtually identical) with the exception of transmission errors.

4. Method according to Claim 3, characterized in that, in the event of the repeated correction measures being unsuccessful, a further error correction is carried out by comparison of the virtually identical information blocks which have been received at different times, one or more information units of those information units in one of the two information blocks which have been identified as being different on the basis of the comparison of the two information blocks being inverted step by step, in that a correction attempt for n information units which have been identified as being different is carried out for each inversion step using the error protection information, and in that, after every correction attempt, the check information is used to determine whether the correction was successful, in that, in the event of successful correction, the error check is terminated and that information block on which an attempt at correction was made first is assessed as the correctly identified information block, and in that, after every unsuccessful correction attempt, the inverted information units on which an attempt has been made to correct are reset to the initial state.

## Revendications

1. Procédé de réception de données de télétexte, composées de bloc d'informations numériques, et se répétant périodiquement. Ces données sont contenues dans un signal TV dans lequel on choisit les périodes auxquelles les données de télétexte se répétant périodiquement sont attendues. Au sein de chaque période, on sélectionne et évalue les blocs d'information reçus. A l'aide d'une information de protection contre les erreurs (FEC) transmise avec le signal et correspondant à la capacité de correction de n erreurs (n est un nombre entier positif.), il est possible de corriger les unités d'information défectueuses transmises et, à l'aide d'une information de vérification (CRC) transmise avec le signal, il est possible de vérifier l'absence d'erreur dans les informations utiles au sein de chaque bloc d'information sélectionné et éventuellement corrigé. La vérification d'erreur pour le bloc d'information concerné sera interrompue prématurément dès que dans un bloc d'information, l'information utile sera reconnue comme exempte d'erreur à l'aide de l'information de vérification transmise avec le signal. Procédé **caractérisé en ce qu'**une ou plusieurs unités d'information du bloc de données concerné sont inversées une à une. A chaque étape d'inversion, une tentative de correction de n unités d'information est effectuée à l'aide de l'information de protection contre les erreurs (FEC) et, après chaque tentative de correction, on détermine à l'aide d'une information de vérification si la correction a été réussie. En cas de succès de la correction, la vérification d'erreur est interrompue. Après chaque tentative de correction infructueuse, les unités d'information inversées et corrigées à titre d'essai sont ramenées à leur état initial.

2. Procédé selon la revendication 1, **caractérisé en ce que** les positions des unités d'information inversées et corrigées à titre d'essai sont conservées en cas d'échec de la correction et sont ensuite omises lors des tentatives de correction suivantes.

3. Procédé selon la revendication 1 ou 2, **caractérisé en ce qu'**en cas d'échec des mesures de correction, ces mêmes mesures de correction sont répétées lors de la réception ultérieure d'un bloc d'information identique (quasi-identique) à l'exception des erreurs de transmission.

4. Procédé selon la revendication 3, **caractérisé en ce qu**'en cas d'échec des mesures de correction répétées, on procède à une autre correction d'erreur par comparaison des blocs d'information quasi-identiques reçus à différents moments. Suite à la comparaison, une ou plusieurs des unités d'information reconnues comme différentes et appartenant à l'un ou aux deux blocs de données concernés sont inversées une à une. A chaque étape d'inversion, une tentative de correction à l'aide de l'information de protection contre les erreurs est effectuée sur n unités d'information reconnues comme différentes et, après chaque tentative de correction, on détermine à l'aide de l'information de vérification si la correction a été réussie. En cas de succès de la correction, la vérification d'erreur est interrompue et le bloc de données corrigé à titre d'essai est considéré comme correct. Après chaque tentative de correction infructueuse, les unités d'information inversées et corrigées à titre d'essai sont ramenées à leur état initial.
